(19) Europäisches Patentamt
European Patent Office
Office européen des brevets

(11) **EP 2 899 512 B1**

(12) **EUROPÄISCHE PATENTSCHRIFT**

(45) Veröffentlichungstag und Bekanntmachung des Hinweises auf die Patenterteilung:
**26.04.2017 Patentblatt 2017/17**

(51) Int Cl.:
*G01D 5/243* *(2006.01)*   *G01P 3/489* *(2006.01)*
*G01D 1/18* *(2006.01)*   *G01D 5/245* *(2006.01)*
*G01P 3/488* *(2006.01)*   *G01D 3/032* *(2006.01)*
*G01R 33/07* *(2006.01)*   *G01B 7/30* *(2006.01)*

(21) Anmeldenummer: **15152928.6**

(22) Anmeldetag: **28.01.2015**

(54) **Erzeugung eines Ausgangssignals**

Generation of an output signal

Génération d'un signal de sortie

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **28.01.2014 DE 102014100963**

(43) Veröffentlichungstag der Anmeldung:
**29.07.2015 Patentblatt 2015/31**

(73) Patentinhaber: **AB Elektronik GmbH
59368 Werne (DE)**

(72) Erfinder: **Rühl, Stefan
59368 Werne (DE)**

(74) Vertreter: **Kalkoff & Partner
Patentanwälte
Martin-Schmeisser-Weg 3a-3b
44227 Dortmund (DE)**

(56) Entgegenhaltungen:
**US-A1- 2004 202 245     US-A1- 2006 071 964
US-A1- 2008 106 273     US-B1- 6 490 807**

**Beschreibung**

Die Erfindung betrifft eine Sensorvorrichtung und ein Verfahren zur Erzeugung eines Ausgangssignals aus einem Sensorsignal.

Insbesondere betrifft die Erfindung die Signalverarbeitung eines Eingangssignals, das nach einer mindestens näherungsweise bekannten Funktion eines Arguments variiert. Beispiele hierfür sind Strom- bzw. Spannungssignale, die nach einer (mindestens im Wesentlichen, d.h. bis auf Störungen) bekannten Funktion variieren bspw. in Abhängigkeit von einer Messgröße. So kann bspw. eine elektrische Sensoranordnung ein Signal erzeugen, das von der jeweils erfassten Messgröße abhängt, bspw. von der Position eines Messobjekts, von einem Winkelwert, etc.

Liegt das Eingangssignal vor und ist die Funktion bekannt, nach der das Eingangssignal von dem Argument abhängt, dann kann aus dem Eingangssignal das Argument, also bspw. die gesuchte Messgröße, durch Berechnung der Umkehrfunktion ermittelt werden.

Bspw. zeigt die DE 195 43 564 A1 eine Anordnung zur berührungslosen Drehwinkelerfassung eines drehbaren Elements. Dabei wird der Drehwinkel einer Welle erfasst, indem Hallsensoren, die gegenüber dem Wellenende angeordnet sind, das Magnetfeld eines am Wellenende angeordneten Magneten ermitteln. Die Hallsensoren sind zueinander um 90° versetzt, so dass eine erste Hallspannung sinusförmig vom Winkel abhängig ist und eine zweite Hallspannung cosinus-förmig. Der Winkel kann dann durch Berechnung des Arcustangens des Verhältnisses der Hallspannungen berechnet werden.

Allerdings kann sich die Berechnung von Umkehrfunktionen im Allgemeinen, und im Falle einer sinus-/cosinus-förmigen Abhängigkeit die Berechnung des Arcustangens im Besonderen, als recht aufwendig erweisen. Insbesondere bei der Echtzeitverarbeitung schnell variierender Signale erweist sich bspw. die Berechnung des Arcustangens nach dem Cordic-Algorithmus als Beschränkung für die Geschwindigkeit der Signalverarbeitung. Zudem gestaltet sich der Aufbau entsprechender Vorrichtungen als sehr aufwändig.

Wird das analog vorliegende Eingangssignal digital verarbeitet, so ergibt sich durch die zeitdiskrete Abtastung stets ein Quantisierungsrauschen, das umso höher ist, je geringer die Differenz zwischen der Frequenz des Signals und der Frequenz der Abtastung ist. Daher erfordern schnell veränderliche Signale hohe Abtastfrequenzen. Aufgrund der weiterhin zeitdiskreten Verarbeitung ist aber auch dann das abgetastete Signal stets mit einem Quantisierungsrauschen behaftet.

Die DE 100 41 736 C1 beschreibt eine Vorrichtung zur Erfassung einer Bewegung, welche Mittel aufweist zum Schalten einer Empfindlichkeit der Vorrichtung für einen Prüfmodus. Die Bewegung wird beispielsweise über einen Sensor, wie zum Beispiel einen Hallsensor, erfasst. Im Prüfmodus ist eine Sensorhilfgröße des Sensorelements, wie z.B. der Hallstrom, und/oder mindestens ein Schwellwert der Auswerteelektronik schaltbar. Der Schwellwert wird durch einen analogen oder digitalen Komparator mit einem Messsignal verglichen. Die Empfindlichkeit der Vorrichtung ist durch die Amplitude der Messgröße des Sensorelements und den Schwellwert der Auswerteelektronik charakterisiert. Im Prüfmodus, abweichend vom Betriebsmodus, wird für Prüfzwecke die Empfindlichkeit reduziert.

In der DE 197 01 260 C2 wird ein Verfahren beschrieben zur Auswertung eines Signals, beispielsweise eines Hallsensors, bei dem Erkennungsschwellenwerte an die sich verändernden Amplituden des Magnetfeldes angepasst werden. Dieses Verfahren umfasst drei Schritte: Im ersten Schritt wird ein Umgebungsmagnetfeld über den Hallsensor erfasst und eine Spannung erzeugt, die proportional zu dem Magnetfeld ist. Im nächsten Schritt wird die stärkste positive Spitzenspannung und stärkste negative Spitzenspannung der Spannung gehalten und nach jedem Zeitintervall auf den neuesten Stand gebracht. Jedes Zeitintervall umfasst eine Vielzahl von positiven Auslenkungen der Spannung. Über die Spannungen werden im folgenden Schritt Schwellwertspannungen erzeugt, welche jeweils feste Prozentsätze der Spannung, des jeweils auf dem neuesten Stand gebrachten Intervall folgenden Intervalls, sind. Mittels dieser Schwellwertspannungen kann über zwei Komparatoren ein binäres Rechteckwellen-Ausgangssignal erzeugt werden.

DE 25 19 417 A1 beschreibt eine Vorrichtung zur Feststellung der An- oder Abwesenheit eines Gegenstandes, bspw. Papiers in einem Kopierer. Die Vorrichtung besteht im Wesentlichen aus einem Sender und ihm gegenüberliegenden Sensor, z.B. für Ultraschallwellen, einer Vorgabeeinheit und einem Komparator. Wird bspw. Papier zwischen Sender und Sensor angeordnet, so ändert sich das Signal, welches vom Sensor ausgeht. Dieses Signal wird vom Komparator mit einem von der Vorgabeeinheit erhaltenen Wert verglichen. Der in der Vorgabeeinheit gespeicherte Wert dient als Referenzwert. Dieser Referenzwert kann bspw. einem Wert entsprechen, der vorliegenden würde, wenn kein Papier zwischen Sender und Sensor angeordnet ist und kann angepasst werden.

In der DE 34 09 795 A1 wird ein temperaturkompensierter Halleffekt-Sensor beschrieben, welcher die Position eines sich bewegenden Körpers erfasst und ein diese Position anzeigendes Ausgangssignal abgibt. Der Sensor weist einen Hallwandler auf, dessen verstärktes Signal an eine Schaltung zur Kompensationsempfindlichkeit und Erzeugung einer Hysterese angelegt wird. Diese Schaltung bestimmt Schaltpunktveränderungen in einem Komparator. Ferner bestehen Schaltungen für Temperaturkompensation, zur Änderung des Schaltpunktes in positiver und negativer Richtung, so dass die effektiven Schaltpunkte des Komparators unabhängig von Temperaturänderungen sind.

Die US 2004/0202245 A1 beschreibt die Verarbeitung von digitalen Bilddaten. Eine Bewegungskompensationseinrichtung umfasst Verarbeitungsmittel, die ein Eingangsbild und ein Referenzbild als Eingabe erhalten und einen Bewegungsvektor zwischen dem Eingangsbild und dem Referenzbild ausgeben. Ein voraussichtliches Bild wird aus dem Referenzbild mit Hilfe des Bewegungsvektors ermittelt. Mittel zur Berechnung einer Verzerrung erhalten als Eingabe das Eingangsbild und das voraussichtliche Bild, um die Verzerrung dazwischen zu ermitteln. Eine Vektorwertkodierung erhält als Eingabe den Bewegungsvektor und gibt einen kodierten Vektorwert aus. Mittel zur Bestimmung eines optimalen Vektors erhalten als Eingabe den Bewegungsvektor, die Verzerrung und den kodierten Vektorwert, um für eine Mehrzahl von auszuwertenden Bewegungsvektoren eine Bewertungsfunktion zu erhalten, die aus der Verzerrung und dem kodierten Vektorwert berechnet wird, um einen optimalen Bewegungsvektor zu bestimmen, bei dem die Bewertungsfunktion einen Minimalwert annimmt.

Die US 2006/0071964 A1 offenbart eine Vorrichtung zum Austreiben von Flüssigkeit mit einer Erkennung für abweichende Zustände. Ein Flüssigkeitstropfen wird durch eine Düse ausgetrieben. Ein piezoelektrisches Element an einer Kammer dient zum Austreiben der Flüssigkeit. Ein Drucksensor erzeugt ein Erkennungssignal des Drucks in der Kammer. Das Erkennungssignal wird über eine vorgegebene Zeitdauer integriert und durch eine Vorrichtung zur Erkennung abweichender Zustände verarbeitet, indem das Ergebnis der Integration mit einer vorgegebenen Schwelle verglichen wird.

Die US 2008/0106273 A1 befasst sich mit einem System und Verfahren zur Signalverarbeitung, bei dem erste und zweite komplementäre Signale über einen Reihenschaltkreis mit ersten und zweiten Erfassungswiderständen und einem dazwischen angeordneten Bauelement gekoppelt sind. Die Spannung über das Bauelement wird im Bezug auf eine Schwelle geregelt und ein Ausgangssignal abhängig von der Eigenimpedanz des Bauteils erzeugt, abhängig von einer Spannung über den ersten Erfassungswiderstand und den zweiten Erfassungswiderstand.

US 6,490,807 B1 offenbart eine Vorrichtung zur Positionsdetektion, mit der eine Relativbewegung von zwei Elementen zueinander ermittelt werden soll. Ein Positionssignal, das ein periodisches Signal enthält, wird aufgezeichnet. Ein erster Detektorkopf bewegt sich relativ zum Aufzeichnungsmedium entlang einer Aufzeichnungsrichtung, um das Positionssignal zu detektieren. Ein zweiter Detektorkopf bewegt sich relativ zum Aufzeichnungsmedium. Die Signale der Detektorköpfe werden durch eine Polar-Umwandlungseinheit in Winkelsignale umgewandelt. Der Ausgangsabschnitt gibt relative Positionsinformationen des Aufzeichnungssignals und des Detektors basierend auf den Winkelinformationen aus. Dabei wird die Rückmeldung begrenzt, so dass wenn ein Absolutwert einer Änderung des Winkelsignals eine vorgegebene Schwelle überschreitet der Absolutwert der Änderung des Winkelsignals auf den Schwellenwert festgelegt wird.

Es ist Aufgabe der Erfindung, eine Sensorvorrichtung und ein Verfahren zur Erzeugung eines Ausgangssignals aus einem Sensorsignal anzugeben, bei denen der Aufwand verringert ist und die somit auch für schnelle Signalverarbeitung geeignet sind.

Die Aufgabe wird gelöst durch eine Sensorvorrichtung gemäß Anspruch 1 und ein Verfahren nach

Anspruch 13. Abhängige Ansprüche beziehen sich auf vorteilhafte Ausführungsformen der Erfindung.

Der Grundgedanke der Erfindung besteht darin, für eine schnelle Signalverarbeitung die Berechnung der Umkehrfunktion zu umgehen und auf andere, vereinfachte Weise ein Ausgangssignal aus dem Eingangssignal zu erzeugen. Für viele Ausgangssignale wird es ausreichen, eine Zuordnung der jeweils aktuellen Messgröße (Argument) zu dem daraus resultierenden Eingangssignal (Funktionswert) nicht kontinuierlich, sondern nur punktuell herzustellen, also für bestimmte, einzelne Werte des Arguments. Bspw. getaktete Signale, z. B. Pulssignale in Abhängigkeit von dem Argument, können auch aus einer solchen nur punktuellen Zuordnung erzeugt werden.

Aus diesem Grund sieht die Erfindung eine Signalverarbeitung vor, bei der nicht zwingend die Umkehrfunktion berechnet werden muss, um das Argument zu ermitteln, sondern für bestimmte, erwartete Argumentwerte der zugehörige Funktionswert berechnet und anschließend das Eingangssignal daraufhin überwacht wird, wann der so berechnete und erwartete Funktionswert auftritt. Der erwartete Argumentwert kann vorgegeben werden und ist somit bekannt. Die aus dem Eingangssignal zu gewinnende Information liegt dann in dem Zeitpunkt, zu dem der erwartete Funktionswert erreicht wird. Eine solche Verarbeitung kann - im Gegensatz zur zeitdiskreten Verarbeitung - auch als argumentdiskrete Verarbeitung, d. h. im Fall eines von einem Winkel als Messgröße abhängigen Funktionswerts als winkeldiskret bezeichnet werden. So ist eine schnelle Signalverarbeitung möglich, so dass insbesondere Echtzeitanforderungen erfüllt werden können. Zusätzlich kann - optional - auch noch die Umkehrfunktion berechnet werden. Dies ist dann aber nicht mehr zeitkritisch, wenn die schnellere Verarbeitung mit der Überwachung des Eingangssignals auf erwartete Funktionswerte für bekannte, vorgegebene Argumentwerte bereits die für das Ausgangssignal notwendigen Informationen geliefert hat.

Dementsprechend umfasst die erfindungsgemäße Vorrichtung eine Komparatoreinheit mit einstellbarem Komparatorschwellenwert, eine Vorgabeeinheit zur Berechnung eines Komparatorschwellenwertes und eine Ausgabeeinheit zur Ausgabe eines Ausgangssignals.

Die Vorgabeeinheit ist dazu ausgelegt, eine Abfolge von Komparatorschwellenwerten vorzugeben. Die vorgegebenen Komparatorschwellenwerte entsprechen dabei mindestens näherungsweise einem Wert der bekannten Funktion für eine Abfolge von Argumentwerten. Die Abfolge von Argumentwerten wird durch die Vorgabeeinheit vorgegeben, d. h. bspw. geeignet ausgewählt, berechnet oder gemäß einer gespeicherten Abfolge nacheinander verwendet. Bspw. können äquidistante Argumentwerte vorgegeben werden, ebenso können aber auch nicht äquidistante Folgen von Argumentwerten verwendet werden. Die Komparatorschwellenwerte werden aus diesen Argumentwerten ermittelt, bspw. durch mindestens näherungsweise Berechnung der Funktion für diese Argumentwerte oder durch Auslesen aus einer Tabelle (look-up table). Dabei kann tabellarisch auch bereits eine Abfolge von vorausberechneten Funktionswerten zu einer vorgegebenen Abfolge von bekannten Argumentwerten gespeichert sein. Generell werden sich die Werte der Komparatorschwellenwerte innerhalb der Abfolge voneinander unterscheiden, d. h. üblicherweise wird nicht stets derselbe Komparatorschwellenwert vorgegeben, sondern mindestens aufeinander folgende Werte unterscheiden sich. Anhand einer so ermittelten Abfolge von Komparatorschwellenwerten wird die Komparatoreinheit eingestellt und überwacht daraufhin das Eingangssignal daraufhin, ob und wann dieses den jeweiligen Komparatorschwellenwert erreicht. Beim Erreichen des jeweiligen Komparatorschwellenwerts signalisiert die Komparatoreinheit ein Umschaltereignis.

Dieses signalisierte Umschaltereignis wird von der Ausgabeeinheit genutzt, um hieraus ein Ausgangssignal zu erzeugen und auszugeben. Jedes Umschaltereignis kann auch als Auslöser für den jeweils nachfolgenden Schritt der erneuten Vorgabe eines Argumentwertes und zugehörigen weiteren Funktionswert dienen. Somit können die Schritte der Signalverarbeitung jeweils nach jedem Umschaltereignis wiederholt werden.

Damit kann bei der erfindungsgemäßen Vorrichtung und dem erfindungsgemäßen Verfahren auf die Berechnung der Umkehrfunktion verzichtet werden, oder zumindest ist die Berechnung der Umkehrfunktion nicht zeitkritisch erforderlich. Somit ist die erfindungsgemäße Signalverarbeitung zur Verarbeitung schnell variierender Signale und einfachen Umsetzung in einer entsprechenden analogen oder digitalen Schaltung geeignet. Zudem erweist sich die erfindungsgemäße Vorwärtsberechnung und anschließende Überwachung des Eingangssignals als wenig anfällig gegen Jitter, so dass das Ausgangssignal das Erreichen der jeweiligen Argumentwerte zeitlich sehr exakt signalisiert. Wie aus den untenstehend näher beschriebenen bevorzugten Ausführungsformen ersichtlich, kann auf eine zeitdiskrete Abtastung des Eingangssignals verzichtet werden, mindestens in einem primären, schnellen Signalpfad. Wie ebenfalls aus den bevorzugten Ausführungsformen ersichtlich, kann es zusätzlich sinnvoll sein, einen sekundären Signalpfad vorzusehen, in dem auch eine zeitdiskrete Verarbeitung stattfindet, bspw. zur Richtungserkennung, zur Verfeinerung der Vorwärtsberechnung etc. Dies dient allerdings zur Unterstützung, während die zeitkritische Verarbeitung im primären, argumentdiskreten Signalpfad erfolgt.

Insbesondere in Fällen, in denen das Ausgangssignal kein zeitdiskretes Signal (d. h. bspw. Digitalsignal nach vorgegebenem Signaltakt), sondern ein getaktetes Signal ist, dessen Taktung diskrete Argumentwerte anzeigen soll, ist es somit möglich, im gesamten (primären) Signalpfad auf zeitdiskrete Verarbeitung zu verzichten und somit Probleme des Quantisierungsrauschens zu vermeiden.

Die erfindungsgemäße Signalverarbeitung ist für verschiedenste Funktionen und Argumentwerte vorteilhaft, insbesondere dann, wenn die Berechnung der Umkehrfunktion einen erhöhten Rechenaufwand mit sich bringt. Besonders geeignet ist die erfindungsgemäße Signalverarbeitung zur Erzeugung eines getakteten Ausgangssignals, also eines Ausgangssignals, bei dem die enthaltene Information über den jeweiligen Argumentwert in der Taktung, d.h. der zeitlichen Veränderung, enthalten ist. Dies gilt insbesondere für gepulste Signale.

Die dem Eingangssignal zugrunde liegende Funktion kann im Grunde beliebiger Natur sein. Dies umfasst bspw. periodische Funktionen ebenso wie nicht-periodische Funktionen. Wird bspw. das Eingangssignal von einem magnetischen Sensor geliefert, der ein Geberrad einer Welle abtastet, wie dies bei Motorwellen in Verbrennungsmotoren bekannt ist, so kann bspw. das Geberrad Zähne entweder mit einer gleichmäßigen Teilung aufweisen, so dass sich eine periodische Funktion in Abhängigkeit vom Argument (Winkel) ergibt, oder das Geberrad weist eine ungleichmäßige Teilung auf. In beiden Fällen kann die erfindungsgemäße argumentdiskrete Verarbeitung verwendet werden. Generell können beliebige, dem Eingangssignal zugrunde liegende Funktionen durch eine Tabelle (Look-Up-Table) repräsentiert und in der Signalverarbeitung verwendet werden.

In einer bevorzugten Ausführungsform handelt es sich bei der dem Eingangssignal zugrunde liegenden Funktion um eine periodische Funktion. Dabei erweist sich die erfindungsgemäße Signalverarbeitung als besonders geeignet für trigonometrische Funktionen, insbesondere sinus/cosinus. In einer besonders bevorzugten Ausführung ist die Funktion eine Sinus- und/oder Cosinus-Funktion, und das Argument ein Winkelwert.

Die Komparatoreinheit kann im Prinzip so aufgebaut werden, dass sie das Erreichen des jeweils vorgegebenen Komparatorschwellenwerts signalisiert, unabhängig davon, aus welcher Richtung dieser erreicht wird, d.h. ob in einer positiven Flanke des Eingangssignals dieses bis auf den Komparatorschwellenwert ansteigt, oder ob bei einer negativen Flanke das Eingangssignal bis auf den Komparatorschwellenwert abfällt. Ein vereinfachter Aufbau ergibt sich aber, wenn stets nur entweder eine positive oder negative Flanke des Eingangssignals einem Komparator zugeführt wird. Hierfür kann die Komparatoreinheit einen Multiplexer aufweisen, der eine Umschaltung des Eingangssignals vornimmt, so dass bei jedem Umschaltereignis stets nur entweder ein durchgängig ansteigender oder fallender Abschnitt, d.h. entweder eine positive oder negative Flanke des Eingangssignals am Komparator anliegt. Der Multiplexer kann demnach im einfachsten Fall in einer ersten Betriebsart das Eingangssignal unverändert zuführen und in einer zweiten Betriebsart das Eingangssignal invertieren. Da die Funktion bekannt ist, kann - jedenfalls zumindest bei monotonem Verlauf des Arguments - stets die Betriebsart gewählt werden, die für das nächste Umschaltereignis sicherstellt, dass stets die positive bzw. negative Flanke anliegt. Ein monotoner Verlauf des Arguments kann bspw. bei vielen Sensoranordnungen angenommen werden (z. B. Drehwinkelsensor einer Welle, die stets nur in einer Drehrichtung dreht). Ist dies nicht zwangsläufig gegeben, kann - wie nachfolgend für bevorzugte Ausführungsformen im Detail beschrieben - neben einer argumentdiskreten Verarbeitung in einem primären Signalpfad parallel eine zusätzliche Verarbeitung in einem sekundären Signalpfad erfolgen, bspw. durch zeitdiskrete Abtastung, um die Veränderungsrichtung des Argumentwertes (d. h. im Fall eines Winkelsensors bspw. die Drehrichtung) zu ermitteln und zu berücksichtigen.

Eine wesentliche Weiterbildung der Erfindung bezieht sich auf ein Eingangssignal mit einem ersten Signalanteil und einem zweiten Signalanteil. Dabei verhalten sich der erste und zweite Signalanteil so, dass sie mit derselben Funktion, aber mit einer Phasenverschiebung in Abhängigkeit von demselben Argument variieren. Ein Beispiel hierfür kann das sinus- und cosinusförmige Ausgangssignal eines Winkelsensors sein, wie anhand von bevorzugten Ausführungsformen erläutert wird.

Für die Verarbeitung eines derartigen Eingangssignals mit erstem und zweitem Signalanteil ist es bevorzugt, dass ein Multiplexer, insbesondere bevorzugt der oben bereits erläuterte Multiplexer, der auch zur Umschaltung der positiven und negativen Flanken vorgesehen ist, zusätzlich dazu ausgebildet ist, um stets zum nächsten Umschaltereignis den jeweils steileren Signalanteil dem Komparator zuzuführen. Durch die Verarbeitung eines möglichst steilen Signalanteils, d.h. eines Signalanteils, der mit einer Variation des Arguments möglichst stark variiert, wird eine besonders genaue Signalverarbeitung ermöglicht. Während bei flachen Signalverläufen die durch den Komparator erzielte Genauigkeit sinkt, können steilere Signalverläufe, bspw. im Fall einer Sinus-/ Cosinus-Funktion ein Abschnitt im Bereich des Nulldurchgangs, sehr genau ausgewertet werden.

Gemäß einer bevorzugten Weiterbildung der Erfindung berechnet die Vorgabeeinheit bei der Ermittlung des neuen Komparatorschwellenwerts die Funktion näherungsweise. Besonders bevorzugt ist die Approximation durch ein Polynom. Bspw. kann eine Sinus-/ Cosinus-Funktion im Bereich ihres Nulldurchgangs (bspw. ± 45°) recht exakt durch ein Polynom dritten Grades approximiert werden. So wird mit geringem Aufwand eine relativ hohe Genauigkeit erzielt.

Gemäß einer Weiterbildung der Erfindung umfasst die Vorrichtung weiter einen Spitzenwertdetektor für das Eingangssignal. Während die Funktion, nach der das Eingangssignal in Abhängigkeit von dem Argument variiert, von ihrer Struktur bekannt ist, kann ein Parameter davon unter Umständen variieren. Im Fall einer periodischen Funktion, im Besonderen einer Sinus- und/oder Cosinus-Funktion, kann sich bspw. die Amplitude ändern. Um bei der Vorgabe von Komparatorschwellenwerten eine korrekte Amplitude zu verwenden, kann mithilfe eines Spitzenwertdetektors diese laufend am Eingangssignal gemessen werden. Der so ermittelte aktuelle Spitzenwert kann dann bei der Berechnung des neuen Komparatorschwellenwerts verwendet werden.

Die Ausgabeeinheit dient dazu, die signalisierten Umschaltereignisse zu verarbeiten und in Abhängigkeit hiervon ein Ausgangssignal auszugeben. Im einfachsten Fall ist es möglich, dass direkt die Umschaltereignisse als Ausgangssignal verwendet werden, also die Ausgabeeinheit sich auf eine reine Durchleitung reduziert, ggf. mit Pegelanpassungen etc. Bevorzugt ist allerdings die Erzeugung eines Ausgangssignals durch die Ausgabeeinheit, das von den Zeitpunkten der Umschaltereignisse abhängt. Besonders bevorzugt kann die Ausgabeeinheit dazu ausgebildet sein, um ein zu den Zeitpunkten der Umschaltereignisse synchrones Pulssignal zu bilden und auszugeben. In dem Pulssignal kann die Information über die aktuelle Messgröße, d.h. das Argument, auf verschiedene Weise enthalten sein, bspw. in der Pulsfrequenz, Pulsdauer und/oder in der Dauer zwischen den Pulsen. In einer bevorzugten Ausführung wird die Information über die jeweils aktuelle Messgröße durch die fallende Flanke des Pulses übermittelt, d.h. die Pulsdauer hängt von dem aktuellen Argumentwert ab.

Eine noch bedeutend höhere Genauigkeit kann in einer speziellen Konstellation erzielt werden, bei der zwei Signale, insbesondere zwei sinusförmige Signale, mit voneinander abweichender Teilung verarbeitet werden. Bspw. können derartige Signale von zwei induktiven Positions- oder Drehwinkelsensoren geliefert werden, die mit voneinander abweichender Teilung zur Erfassung der Position bzw. des Drehwinkels desselben Elements angeordnet sind. Hierfür kann vorgesehen sein, dass ein erstes Eingangssignal von einer ersten Komparatoreinheit verarbeitet wird und ein zweites Eingangssignal von einer zweiten Komparatoreinheit. Beiden Komparatoreinheiten werden einstellbare Komparatorschwellen vorgegeben. Mit einer derartigen Signalverarbeitung zweier Signale unterschiedlicher Frequenz kann nach Art einer Nonius-Berechnung eine hochgenaue Ermittlung des jeweiligen Argumentwerts erzielt werden.

In einer besonders bevorzugten Ausführung ist dabei der zweite Komparator als Fensterkomparator ausgebildet, zum Vergleich des Eingangssignals mit einer oberen und einer unteren Schwelle. Ein Triggersignal wird erzeugt, wenn ein Umschaltereignis des ersten Komparators signalisiert wird und gleichzeitig das Ausgangssignal des zweiten Komparators signalisiert, dass der Wert des Eingangssignals im Fenster zwischen der oberen und unteren Schwelle des Fensterkomparators liegt.

Die erfindungsgemäße Vorrichtung zur Signalverarbeitung kann insbesondere bevorzugt in einer Sensorvorrichtung dazu genutzt werden, um aus einem von einer Sensoranordnung gelieferten Sensorsignal ein Ausgabesignal, insbesondere Pulssignal zu erzeugen.

Nachfolgend werden Ausführungsformen der Erfindung anhand von Zeichnungen näher beschrieben. Dabei zeigen:

Fig. 1 ein Prinzipschaltbild einer ersten Ausführungsform einer Signalverarbeitungsschaltung;

Fig. 2 eine schematische Ansicht einer Sensorvorrichtung;

Fig. 3 ein Blockschaltbild einer zweiten Ausführungsform;

Fig. 4 ein Diagramm des Zeitverlaufs eines Eingangssignals und verschiedener Komparatorschwellenwerte in der zweiten Ausführungsform;

Fig. 5 ein Blockschaltbild einer dritten Ausführungsform einer Signalverarbeitungsvorrichtung;

Fig. 6, Fig. 7 in Diagrammform verschiedene Signale der dritten Ausführungsform gemäß Fig. 5.

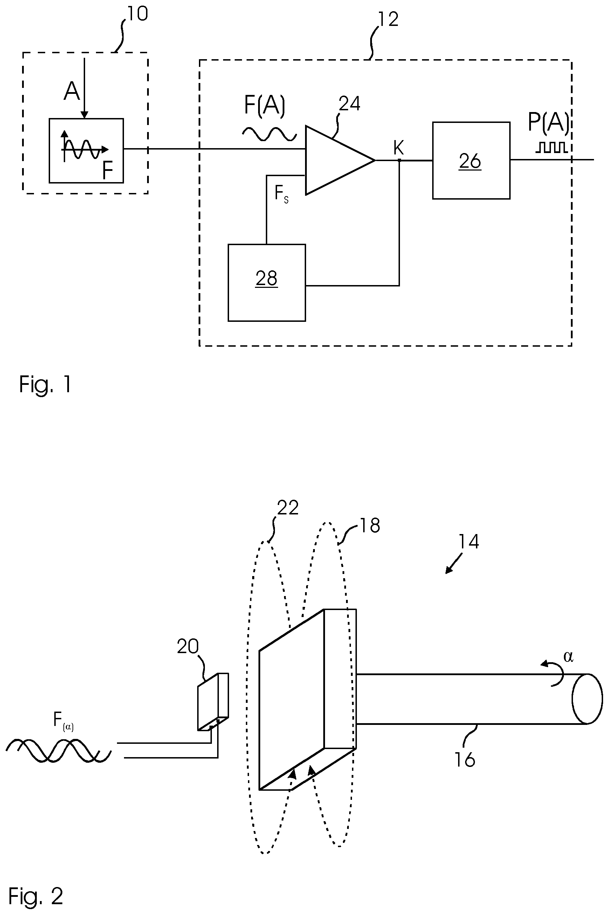

Fig. 1 zeigt schematisch eine erste Ausführungsform einer Vorrichtung, insbesondere einer Schaltung zur Erzeugung eines Ausgangssignals. Ein von einer ersten Einheit 10 geliefertes Signal F wird in einer zweiten Einheit 12 verarbeitet und daraus ein Ausgangssignal P, im gezeigten Beispiel in Form eines Pulssignals, erzeugt.

Das Eingangssignal F ist dabei eine bekannte Funktion eines Arguments A, bspw. einer Messgröße eines Sensors.

In Fig. 2 ist beispielhaft eine Sensoranordnung 14 gezeigt, mit der der Drehwinkel $\alpha$ einer Welle 16 ermittelt werden kann. Am Ende der Welle 16 ist ein Magnet 18 angeordnet, vor dem sich ein 2-kanaliger Hall-Sensor 20 befindet, der die Stärke des Magnetfelds 22 erfasst. Der Hall-Sensor 20 umfasst zwei unter 90° zueinander angeordnete Hall-Sensorelemente und liefert somit ein Ausgangssignal F mit zwei Signalanteilen. Aufgrund der in Fig. 2 gezeigten Anordnung hängen beide Signalanteile sinus-förmig vom Winkel $\alpha$ ab, so dass aufgrund der Phasenverschiebung um 90° ein erster und zweiter Signalanteil folgende Abhängigkeit vom Winkel $\alpha$ zeigen

$$F_1(\alpha) = B_{max} \sin(\alpha)$$

$$F_2(\alpha) = B_{max} \cos(\alpha)$$

wobei die Amplitude $B_{max}$ abhängig ist vom Aufbau, Auslegung des Magneten, etc.

Somit ist die Sensoranordnung 14 aus Fig. 2 ein Beispiel einer ersten Einheit 10 aus Fig. 1, die ein Eingangssignal F (in diesem Fall mit zwei Signalanteilen) liefert, das eine bekannte funktionale Abhängigkeit von einer Messgröße als Argument hat.

Die zweite Einheit 12 aus Fig. 1 verarbeitet dieses von dem Argument A abhängige Eingangssignal F und erzeugt daraus ein gepulstes Ausgangssignal P, das ebenfalls von dem Argument A abhängt, also eine auslesbare Information über den Wert des Arguments A enthält. Diese Information ist in der zeitlichen Abfolge der Pulse des Ausgangssignals P enthalten.

Mit der in Fig. 1 gezeigten Signalverarbeitung kann dabei auf die Berechnung der Umkehrfunktion der Funktion F (A) verzichtet werden. Hierzu wird das Eingangssignal F einer Komparatoreinheit 24 zugeführt, die das Eingangssignal F bzw. mindestens einen Signalanteil hiervon, mit einem Komparatorschwellenwert Fs vergleicht. Das Ergebnis des Vergleichs wird als Komparatorsignal K ausgegeben und einer Ausgabeeinheit 26 zugeführt.

Der Komparatorschwellenwert $F_s$ wird der Komparatoreinheit 24 durch eine Vorgabeeinheit 28 zugeführt. Dabei verfolgt die Vorgabeeinheit 28 durch die aufeinander folgende Vorgabe verschiedener Komparatorschwellenwerte den bekannten Verlauf der Funktion F(A) bzw. sieht erwartete Werte des Eingangssignals F voraus. Diese Vorhersage von Werten beruht auf einem angenommenen Verlauf von Werten des Arguments A, der vorteilhafter Weise stetig und insbesondere monoton sein sollte. Bspw. im Fall der in Fig. 2 gezeigten Sensoranordnung heißt dies, dass sich die Welle 16 stets nur in eine Richtung dreht, der Winkel $\alpha$ als Argument A somit einen monotonen Verlauf aufweist. Wie in nachfolgenden Beispielen gezeigt, ist aber ein solcher monotoner Verlauf keine zwingende Vorraussetzung, sondern der Verlauf, bspw. hier die Drehrichtung, kann ggfs. auch separat durch zusätzliche Sensoren oder durch eine zusätzliche Signalverarbeitung des Eingangssignals F ermittelt und dann in der Signalverarbeitung gem. Fig. 1 berücksichtigt werden.

Die Arbeitsweise der Vorrichtung 12 aus Fig. 1 ist wie folgt: Zunächst wird ein erster Komparatorschwellenwert $F_{S1}$ vorgegeben als nächster erwarteter Wert des Eingangssignals für ein Argument $A_1$ also $F_{S1} = F(A_1)$.

Nach Einstellung des ersten Komparatorschwellenwerts $F_{S1}$ wird abgewartet, bis das zeitlich variierende Eingangssignal F diesen Komparatorschwellenwert $F_{S1}$ erreicht. Dies wird im Komparatorsignal K in Form eines Umschaltereignisses signalisiert. Nach dem Umschaltereignis gibt die Vorgabeeinheit 28 jeweils den nächsten Komparatorschwellenwert vor. Dieser wird ermittelt durch Vorwärtsberechnung der Funktion F(A) für den nächsten erwarteten Argumentwert $A_2$, also $F_{S2} = F(A_2)$.

Der so ermittelte neue Komparatorschwellenwert $F_{S2}$ wird wiederum der Komparatoreinheit 24 zugeführt, die daraufhin wieder das Eingangssignal F überwacht, bis dieses den neuen Komparatorschwellenwert $F_{S2}$ erreicht. Dies wird durch ein erneutes Umschaltereignis im Komparatorsignal K signalisiert, woraufhin die Vorgabeeinheit 28 den nächsten Komparatorschwellenwert ermittelt usw.

Die Ausgabeeinheit 26 verarbeitet das Komparatorsignal K, um daraus das gepulste Ausgangssignal P zu erstellen. Dabei enthält das Komparatorsignal K in Form der Zeitpunkte der signalisierten Umschaltereignisse Informationen über den Wert des Eingangssignals F und damit auch den Wert des Arguments A zu diesen Zeitpunkten, da die vorgegebene Abfolge der Argumentwerte A bekannt ist. Die Ausgabeeinheit 26 bildet hieraus das Ausgangssignal P entsprechend einem hierfür festgelegten Protokoll. Hierfür werden in nachfolgenden detaillierteren Ausführungen Beispiele gegeben.

Dabei liegt den folgenden Ausführungsbeispielen stets ein Eingangssignal F zugrunde wie es bspw. durch die Winkelsensoranordnung 14 (Fig. 2) geliefert wird, d.h. ein stetiges, im Wesentlichen monoton variierendes Argument A führt zu einem Funktionssignal F mit zwei Funktionsanteilen, die nach einer Sinus- bzw. Cosinus-Funktion in Abhängigkeit vom Argument A verlaufen.

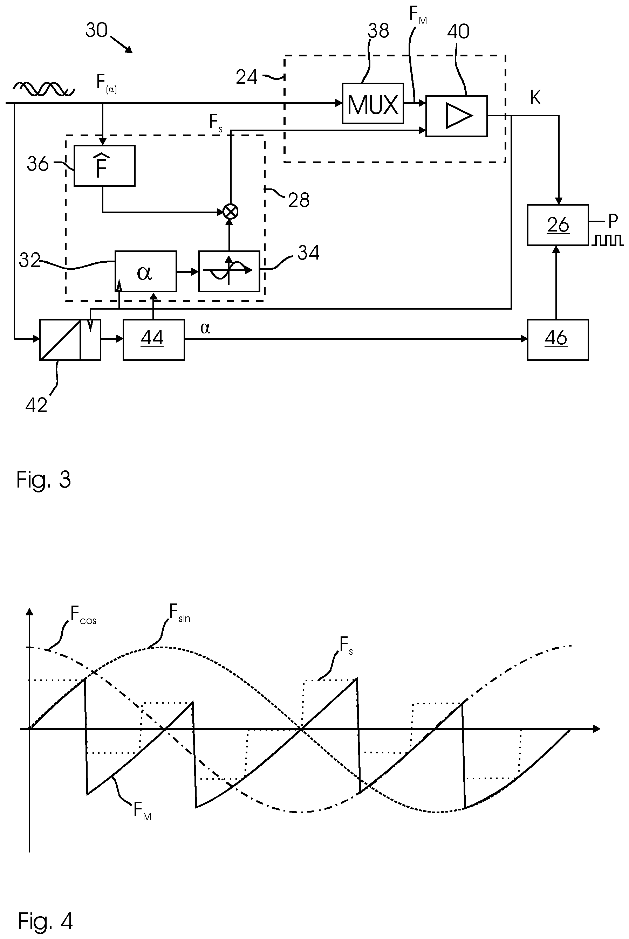

Fig. 3 zeigt in Form eines Blockschaltbilds eine Schaltung 30 zur Verarbeitung eines solchen Eingangssignals F. Die Schaltung 30 ist eine detailliertere Ausführung der generellen Struktur der ersten Ausführungsform (Fig. 1), wobei gleiche Bezugszeichen gleiche Elemente bezeichnen.

Das Eingangssignal F wird in einem primären Signalpfad der Komparatoreinheit 24 verarbeitet, deren Ausgangssignal K der Ausgabeeinheit 26 zugeführt wird. Die Komparatorschwelle $F_S$ für die Komparatoreinheit 24 wird dabei durch die Vorgabeeinheit 28 vorgegeben. Das Komparatorsignal K wird der Ausgabeeinheit 26 zugeführt und zusätzlich als Trigger für die Vorgabeeinheit 28 verwendet.

Innerhalb der Vorgabeeinheit 28 gibt zunächst eine Winkelvorgabeeinheit 32 den nächsten erwarteten Winkelwert, d.h. Argumentwert, vor. Ausgehend vom zuvor vorgegebenen letzten Winkelwert kann der erwartete nächste Winkelwert - bei bekannter Drehrichtung - durch Addition einer festen Teilung ermittelt werden. Wird bspw. die 360°-Umdrehung in einer Teilung N mit N=10 unterteilt, so werden die Winkelwerte in 36°-Schritten vorgegeben. Allerdings müssen die Schritte nicht zwingend äquidistant sein.

Aus dem so vorgegebenen Winkelwert wird in einer Berechnungseinheit 34 ein Funktionswert berechnet. Statt hier die Sinus- oder Cosinus-Funktion genauer zu berechnen, wird diese durch ein Polynom dritten Grades approximiert:

$$f(x) = ax^3 + cx$$

wobei a = -8,42521 x $10^{-7}$ und c = 0,01742766.

Im Intervall -45° bis +45° kann damit eine Sinus-Kurve bis auf eine Genauigkeit von +/-0,04% näherungsweise berechnet werden. Wie nachfolgend erläutert, wird die Berechnung dabei stets so durchgeführt, dass tatsächlich die Sinus-Funktion in diesem Intervall berechnet wird.

Der so berechnete Funktionswert wird mit einem Spitzenwert multipliziert, der aus dem Eingangssignal F durch einen Spitzenwertdetektor 36 ermittelt wird.

Der so berechnete, nächste erwartete Funktionswert Fs wird der Komparatoreinheit 24 als Komparatorschwellenwert zugeführt. Dort wird dieser Wert mit dem durch einen Multiplexer 38 modifizierten Eingangssignal F verglichen.

Der Multiplexer 38 schaltet das dem nachgelagerten Komparator 40 zugeführte Signal so um, dass stets ein Signal $F_M$ mit hoher Steigung anliegt, wobei die Steigung stets positiv ist. In Abhängigkeit davon, in welchem Bereich der Winkelwert liegt, der bei der Berechnung des nächsten Komparatorschwellenwerts verwendet wurde, wird dabei entsprechend der folgenden Tabelle entweder der Sinus-Anteil oder der Cosinus-Anteil des Eingangssignals F dem Komparator 40 zugeführt, und dieser Anteil entweder mit positiver oder invertierter Polarität:

| Bereich | Signalanteil | Polarität |
|---|---|---|
| 0° - 45° | sinus | positiv |
| 45° - 135° | cosinus | invertiert |
| 135° - 225° | sinus | invertiert |
| 225° - 315° | cosinus | positiv |
| 315° - 360° | sinus | positiv |

Das so umgeschaltete Eingangssignal $F_M$ wird dem Komparator 40 zugeführt und mit dem jeweils aktuellen Komparatorschwellenwert $F_S$ verglichen. Aufgrund der oben genannten Umschaltung steigt das Signal stets an, ist also zunächst kleiner als der Komparatorschwellenwert, so dass das Komparatorsignal Null ist. Zu dem Zeitpunkt, zu dem das Argument, also der nächste erwartete Winkel, den von der Vorgabeeinheit 28 zugrunde gelegten nächsten Wert erreicht, stimmt auch das umgeschaltete Eingangssignal mit dem Komparatorschwellenwert $F_S$ überein und das Komparatorsignal K signalisiert ein Umschaltereignis.

Durch das Komparatorsignal K wird die Vorgabeeinheit 28 getriggert, um den nächsten Komparatorschwellenwert $F_S$ vorzugeben.

Das Komparatorsignal K wird der Ausgabeeinheit 26 zugeführt, um aus den Zeitpunkten der Umschaltereignisse ein Pulssignal P zu generieren. Dieses Pulssignal kann je nach gewünschtem Protokoll sehr unterschiedlich generiert werden. Bspw. kann bei jedem Umschaltereignis ein Puls ausgelöst werden. Aus einem solchen Pulssignal kann durch eine nachfolgende Signalverarbeitung bei Kenntnis der bekannten Teilung N dann der jeweils aktuelle Winkelwert $\alpha$ ermittelt werden.

In komplexeren Ausgabeprotokollen kann bspw. vorgesehen sein, dass je nach Umdrehungsgeschwindigkeit der Welle 16 unterschiedliche Pulssignale ausgegeben werden. Bspw. kann der Abstand zwischen der fallenden Flanke eines ersten Pulses und der steigenden Flanke des darauf folgenden Pulses einer Dauer entsprechen, die die aktuell gewählte Teilung N angibt (z.B. 90 $\mu$s OFF - Zeit als Anzeige für 200 Pulse pro Umdrehung, 45 $\mu$s als Anzeige für 60 Pulse pro Umdrehung). Die Positionsinformation kann bei diesem Protokoll durch die fallende Flanke der jeweiligen Pulse repräsentiert sein, also durch die Pulsdauer.

Im Ausführungsbeispiel gemäß Fig. 3 weist die Signalverarbeitung zusätzlich noch einen zweiten, sekundären Signalpfad zur Verarbeitung des Eingangssignals F auf. Dieses wird durch einen A/D-Wandler 42 mit sample-and-hold-Stufe digitalisiert und durch eine Berechnungseinheit 44 aus den so ermittelten digitalen Werten beider Signalanteile der Winkel $\alpha$ errechnet, bspw. mittels des CORDIC-Algorithmus. Der so ermittelte Winkelwert wird von einer Verarbeitungseinheit 46 verarbeitet, so dass bspw. Stillstand und Drehrichtung erkannt werden können. Die Verarbeitungseinheit 46 kann die Ausgabeeinheit 26 dann ansteuern um bspw. die Drehrichtung oder einen Stillstand entsprechend zu signalisieren.

Weiter kann der ermittelte Winkelwert $\alpha$ auch innerhalb der Winkelvorgabeeinheit 32 verwendet werden, um den korrekten nächsten Winkelwert zu ermitteln, bspw. im Fall einer Drehrichtungsumkehr. Der Winkelwert wird von der Winkelvorgabeeinheit 32 auch an den Multiplexer 38 zur Auswahl der korrekten Betriebsart bzw. Signalumschaltung übermittelt.

Nachfolgend wird die Funktionsweise der Signalverarbeitung in der Schaltung 30 anhand der in Fig. 4 dargestellten Zeitverläufe der beteiligten Größen noch einmal im Detail erläutert. Dabei ist in Fig. 4 der Sinus-Anteil $F_{sin}$ des Eingangssignals F gestrichelt und der Cosinus-Anteil $F_{cos}$ strichpunktiert gezeigt. Das durch den Multiplexer 38 jeweils nach der oben genannten Tabelle umgeschaltete Signal $F_M$ ist als durchgehende Linie dargestellt. Die jeweiligen Komparatorschwellenwerte $F_S$ sind gepunktet gezeigt.

Bei einer Teilung N=10, d.h. beispielhaft 10 Pulsen pro Umdrehung, ergibt sich der dargestellte Signalverlauf. Das umgeschaltete Eingangssignal $F_M$ steigt stets an und verläuft relativ steil (d.h. innerhalb eines Bereichs von +/- 45° der Sinus-Funktion). Die aufeinander folgenden Komparatorschwellenwerte werden stets so vorgegeben, wie es dem erwarteten Wert der so umgeschalteten Funktion $F_M$ in 36°-Schritten entspricht.

Das hieraus resultierende Komparatorsignal K enthält demnach sehr exakt Informationen über die Zeitpunkte, zu denen das Eingangssignal F das Erreichen jeder der in 36°-Schritten aufeinander folgende Positionen anzeigt.

In praktischen Signalverarbeitungsschaltungen und -sensoren kann eine deutlich höhere Teilung N verwendet werden, bspw. von N=100 oder mehr. Aufgrund des sehr einfachen Aufbaus der Schaltung 30 ist diese für die Verarbeitung von sehr schnell variierenden Eingangssignalen F geeignet.

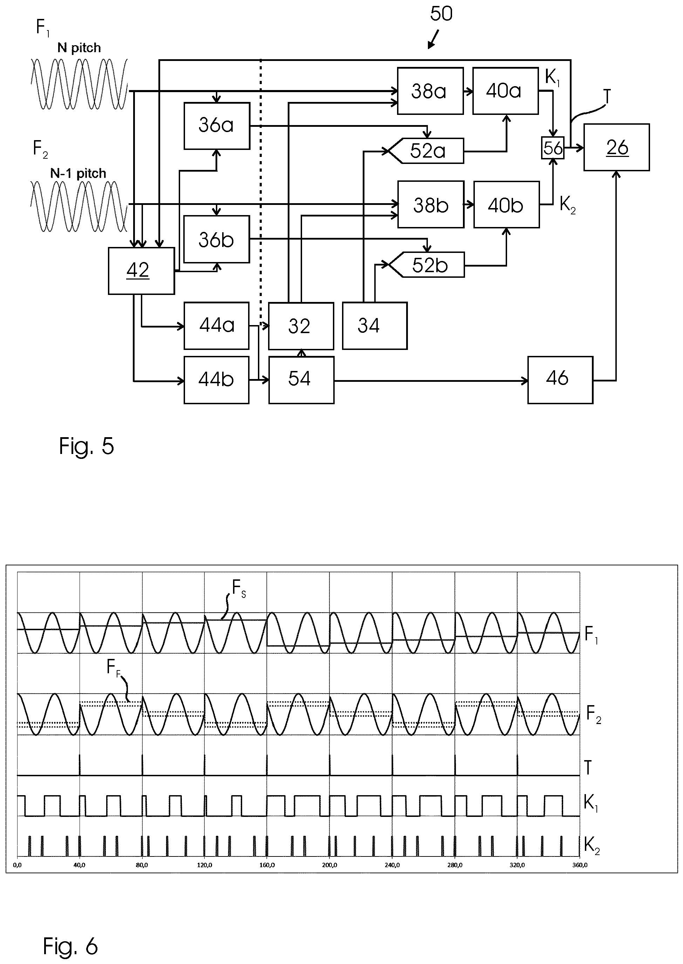

Fig. 5 zeigt eine dritte Ausführungsform einer Signalverarbeitungsschaltung 50. Diese verarbeitet zwei Eingangssignale $F_1$, $F_2$, jeweils mit Sinus- und Cosinus-Signalkomponenten. Jedes der beiden Eingangssignale $F_1$, $F_2$ kann dabei bspw. geliefert werden durch einen induktiven Sensor wie bspw. beschrieben in WO 2003/038379. Dabei haben die Eingangssignale $F_1$, $F_2$ unterschiedliche Teilung, so dass sie zu einer genaueren Feststellung der Position einer drehenden Welle verwendet werden können, indem die Signale nach dem Nonius-Prinzip verarbeitet werden. Ein Beispiel einer solchen Sensoranordnung mit zwei induktiven Sensoren am selben Element ist beschrieben in EP 1 666 836 A2.

Die Struktur der Schaltung 50 entspricht im Wesentlichen einer Verdopplung der Schaltung 30 zur Verarbeitung eines Eingangssignals. Dabei umfasst der primäre Signalpfad zwei weitgehend identisch aufgebaute Teile, deren Ergebnisse am Ende miteinander verknüpft werden. Da die Struktur und Funktionsweise generell oben bereits erläutert ist, werden die jeweiligen Bestandteile hier nur kurz genannt, während sich die Beschreibung im Folgenden auf die Unterschiede konzentriert.

Zu den beiden Eingangssignalen $F_1$, $F_2$ wird durch Spitzenwertdetektoren 36a, 36b jeweils die Amplitude ermittelt. In beiden Teilen des primären Signalpfads werden die Eingangssignale $F_1$, $F_2$ durch Multiplexer 38a, 38b der oben beschriebenen Art umgeschaltet und das entsprechend geschaltete Signal Komparatoren 40a, 40b zugeführt, die Komparator-Ausgangssignale $K_1$, $K_2$ ausgeben. Dabei ist der Komparator 40a des ersten Teils des Signalpfads ein üblicher Komparator wie zuvor beschrieben, während der Komparator 40b des zweiten Teils des primären Signalpfads als Fensterkomparator ausgebildet ist, d.h. er ermittelt, ob das umgeschaltete Eingangssignal sich in einem vorgegebenen Fenster zwischen einem Minimal- und Maximalwert befindet. Dieses Fenster wird aus dem angelegten Komparatorschwellenwert ermittelt, indem zur Bildung der oberen Schwelle eine feste Toleranz addiert und zur Bildung der unteren Schwelle die Toleranz subtrahiert wird.

Der jeweils nächste Winkel wird durch eine Winkel-Vorgabeeinheit 32 vorgegeben und durch eine Berechnungseinheit 34 berechnet. Der so errechnete Wert wird durch einen multiplizierenden Digital-/Analog-Konverter 52a, 52b mit dem jeweiligen durch die Spitzenwertdetektoren 36a, 36b ermittelten Amplitudenwert multipliziert und dem jeweiligen Komparator 40a, 40b zugeführt.

Parallel werden in einem sekundären Signalpfad die Eingangssignale $F_1$, $F_2$ einem Analog-/Digital-Konverter 42 zugeführt und die jeweils ermittelten digitalisierten Werte mittels CORDIC in Berechnungseinheiten 44a, 44b berechnet.

Mit einer UND-Verknüpfungseinheit 56 werden die Ausgangssignale des Komparators 40a des ersten Teils des primären Signalpfades und des Fensterkomparators 40b des zweiten Teils des primären Signalpfades logisch so verknüpft, dass ein Ausgangspuls durch die Ausgabeeinheit 26 nur generiert wird, wenn gleichzeitig im ersten Teil des primären Signalpfads ein Umschaltereignis signalisiert wird und im zweiten Teil des primären Signalpfads der Fensterkomparator 40b ein Signal innerhalb eines Akzeptanzfensters signalisiert.

Parallel werden im sekundären Signalpfad ebenfalls die digital berechneten Werte in einer Nonius-Einheit 54 gemeinsam verarbeitet und das gemeinsam gebildete Ergebnis wie im oben beschriebenen zweiten Ausführungsbeispiel der Verarbeitungseinheit 46 zugeführt.

Fig. 6 zeigt für ein erstes Eingangssignal $F_1$ mit einer Teilung N = 16 und ein zweites Eingangssignal $F_2$ mit einer Teilung N = 15 die Signalverläufe über 360°. Gezeigt sind der Verlauf der jeweiligen Signale $F_1$, $F_2$ des Komparatorschwellenwerts Fsdes ersten Teils des Signalpfads und des Fensters $F_F$ des zweiten Teils des Signalpfads. Gezeigt sind weiter das Signal $K_1$ des ersten Komparators 40a, das Signal $K_2$ des Fensterkomparators 40b und das hieraus durch UND-Verknüpfung gewonnene Trigger-Signal T.

Wie dargestellt erfolgen die Ausgabe eines Pulses und die Berechnung neuer Vorgabewerte stets nur dann, wenn gleichzeitig die Komparatorsignale $K_1$ und $K_2$ anliegen.

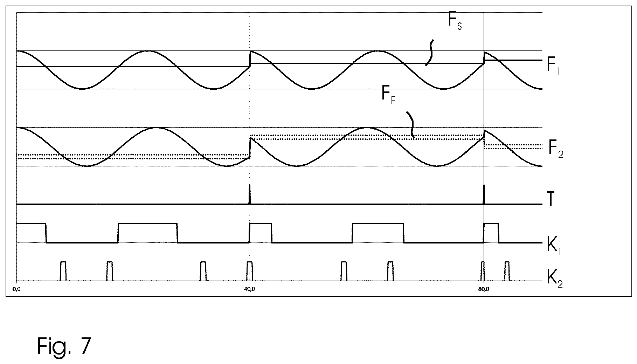

In Fig. 7 ist ein Teil des Signalverlaufs aus Fig. 6 vergrößert noch einmal gezeigt. Wie dort ersichtlich wird zwar im Intervall 0° - 40° mehrfach durch das Komparatorsignal $K_1$ ein Umschaltereignis signalisiert, allerdings nicht zum selben Zeitpunkt, zu dem auch der Fensterkomparator 40b ein Komparatorsignal $K_2$ liefert. Erst exakt bei der 40°-Position liegen beide Komparatorsignale überein, was zur Auslösung des Trigger-Impulses T führt.

Entsprechend werden in jeweils 40°-Schritten Pulse durch die Ausgabeeinheit 26 ausgegeben und gleichzeitig die Berechnung neuer Vorgabewerte gestartet.

So kann durch Anwendung des Nonius-Prinzips eine noch erheblich genauere Auswertung erfolgen.

**Patentansprüche**

**1.** Sensorvorrichtung mit

- einer Sensoranordnung (14) zur Erzeugung eines Sensorsignals (F)
- und einer Vorrichtung (12) zur Erzeugung eines zu Zeitpunkten von Umschaltereignissen synchronen Ausgangssignals (P) mindestens aus dem Sensorsignal (F), das nach einer für die Sensorvorrichtung bekannten Funktion eines Arguments (A, α) variiert und wobei das Sensorsignal (F) der Vorrichtung (12) als Eingangssignal zugeführt wird, und das Ausgangssignal (P) eine Pulsflanke enthält, die Vorrichtung (12) umfassend

- eine Komparatoreinheit (24) zur Signalisierung von Umschaltereignissen mittels Erzeugung eines Komparatorsignals, mit einem auf einen Vorgabewert ($F_S$) einstellbaren Komparatorschwellenwert, wobei der Komparatorschwellenwert so eingestellt wird, dass er dem Wert der Funktion bei einem ersten erwarteten Argumentwert entspricht, und wobei die Komparatoreinheit (24) dazu ausgelegt ist, das Eingangssignal (F) mit dem Komparatorschwellenwert (Fs) zu vergleichen, das Eingangssignal (F) daraufhin zu überwachen, ob und wann es den Komparatorschwellenwert (Fs) erreicht und beim Erreichen des Komparatorschwellenwerts ein Umschaltereignis zu signalisieren,

- eine Vorgabeeinheit (28), dazu ausgelegt, um ausgelöst durch das Umschaltereignis einen neuen Komparatorschwellenwert (Fs) vorzugeben, indem ein zweiter, erwarteter Argumentwert vorgegeben und daraus der neue Komparatorschwellenwert (Fs) durch mindestens näherungsweise Bestimmung des Werts der Funktion für einen zweiten erwarteten Argumentwert ermittelt wird,

- und eine Ausgabeeinheit (26) zur Ausgabe eines Ausgangssignals (P) in Abhängigkeit vom Komparatorsignal.

**2.** Sensorvorrichtung nach Anspruch 1, bei der

- die Vorgabeeinheit (28) dazu ausgelegt ist, ausgelöst jeweils durch das Komparatorsignal eine Abfolge von erwarteten Argumentwerten vorzugeben und daraus eine Abfolge von Komparatorschwellenwerten (Fs) zu ermitteln.

**3.** Sensorvorrichtung nach Anspruch 2, bei der

- die Abfolge der erwarteten Argumentwerte äquidistant ist.

**4.** Sensorvorrichtung nach einem der vorangehenden Ansprüche, bei der

- das Argument ein Winkelwert (α) ist
- und die Funktion eine Sinus- oder Cosinus-Funktion.

**5.** Sensorvorrichtung nach einem der vorangehenden Ansprüche, bei der

- das Ausgabesignal (P) ein getaktetes Signal ist, dessen Taktung abhängig ist von den Zeitpunkten der Komparatorsignale.

**6.** Sensorvorrichtung nach einem der vorangehenden Ansprüche, bei der

- ein Multiplexer (38) vorgesehen ist, um das Eingangssignal (F) einem Komparator (40) stets so zuzuführen, dass entweder bei jedem Umschaltereignis stets nur eine ansteigende Flanke des Eingangssignals anliegt, oder bei jedem Umschaltereignis stets nur eine fallende Flanke des Eingangssignals anliegt, und/oder das Eingangssignal invertiert wird.

**7.** Sensorvorrichtung nach einem der vorangehenden Ansprüche, bei der

- das Eingangssignal (F) mindestens einen ersten Signalanteil und einen zweiten Signalanteil aufweist, wobei der erste und der zweite Signalanteil nach derselben Funktion aber mit einer Phasenverschiebung in Abhängigkeit von dem Argument (A, α) variieren,
- wobei ein Multiplexer (38) vorhanden ist, um von dem Eingangssignal (F) stets nur den zum nächsten Umschaltereignis steileren Signalanteil dem Komparator (40) zuzuführen.

**8.** Sensorvorrichtung nach einem der vorangehenden Ansprüche, bei der

- die Vorgabeeinheit (28) bei der Ermittlung des neuen Komparatorschwellenwerts (Fs) die Funktion durch ein Polynom approximiert berechnet.

**9.** Sensorvorrichtung nach einem der vorangehenden Ansprüche, bei der

- ein Spitzenwertdetektor (36) für das Eingangssignal (F) vorgesehen ist,
- und die Vorgabeeinheit (28) bei der Ermittlung des neuen Komparatorschwellenwerts ($F_S$) den vom Spitzenwertdetektor (36) gelieferten Spitzenwert des Eingangssignals (F) verwendet.

**10.** Sensorvorrichtung nach einem der vorangehenden Ansprüche, bei der

- die Ausgabeeinheit (26) dazu ausgebildet ist, um ein zu den Zeitpunkten des Umschaltereignisses synchrones Pulssignal (P) zu bilden und auszugeben.

**11.** Sensorvorrichtung nach einem der vorangehenden Ansprüche, bei der

- ein erstes und ein zweites periodisches Eingangssignal unterschiedlicher Teilung verarbeitet werden,
- wobei zur Verarbeitung des ersten Eingangssignals die Komparatoreinheit als erste Komparatoreinheit und die Vorgabeeinheit als erste Vorgabeeinheit vorhanden sind, um das erste Eingangssignal mit einem ersten Komparatorschwellenwert zu vergleichen und das Komparatorsignal als erstes Komparatorsignal (K1) zu erzeugen,
- und zur Verarbeitung des zweiten Eingangssignals eine zweite Komparatoreinheit und eine zweite Vorgabeeinheit vorhanden sind, um das zweite Eingangssignal mit mindestens einem zweiten Komparatorschwellenwert zu vergleichen und ein zweites Komparatorsignal (K2) zu erzeugen.

**12.** Sensorvorrichtung nach Anspruch 12, bei der

- der zweite Komparator (40b) als Fensterkomparator zum Vergleich mit einer unteren und einer oberen Schwelle ausgebildet ist,
- wobei ein Trigger-Signal (T) nur ausgegeben wird, wenn bei einem Umschaltereignis der ersten Komparatoreinheit der Wert des zweiten Signals ($F_2$) in einem Fenster zwischen der oberen und der unteren Schwelle liegt.

**13.** Verfahren zur Erzeugung eines zu Zeitpunkten von Umschaltereignissen synchronen Ausgangssignals (P), das eine Pulsflanke enthält, aus mindestens einem Sensorsignal einer Sensoranordnung als Eingangssignal (F), das nach einer bekannten Funktion eines Arguments (A, α) variiert, bei dem

- eine Komparatoreinheit Umschaltereignisse mittels Erzeugung eines Komparatorsignals signalisiert, indem sie das Eingangssignal (F) mit einem Komparatorschwellenwert ($F_S$) vergleicht, das Eingangssignal (F) daraufhin überwacht, ob und wann es den Komparatorschwellenwert (Fs) erreicht und beim Erreichen des Komparatorschwellenwerts das Komparatorsignal erzeugt,
- wobei der Komparatorschwellenwert ($F_S$) so eingestellt wird, dass er dem Wert der Funktion bei einem ersten erwarteten Argumentwert entspricht,
- und wobei ausgelöst durch die Signalisierung des Umschaltereignisses ein neuer Komparatorschwellenwert ($F_S$) vorgegeben wird, indem ein zweiter erwarteter Argumentwert vorgegeben und daraus der neue Komparatorschwellenwert ($F_S$) durch mindestens näherungsweise Bestimmung des Wertes der Funktion für den zweiten erwarteten Argumentwert ermittelt wird,
- und wobei ein Ausgangssignal (P) in Abhängigkeit von dem Komparatorsignal ausgegeben wird.

**Claims**

1. A sensor device having:

   - a sensor arrangement (14) for generating a sensor signal (F)
   - and a device (12) for generating an output signal (P) synchronous with the times of switchover events at least from the sensor signal (F) which varies according to a function of an argument (A, $\alpha$) that is known to the sensor device, and wherein the sensor signal (F) of the device (12) is supplied as an input signal, and the output signal (P) contains a pulse edge, the device (12) comprising:
   - a comparator unit (24) for signaling switchover events by generating a comparator signal with a comparator threshold that can be set to a default value ($F_s$), wherein the comparator threshold is set such that it corresponds to the value of the function at a first anticipated argument value, and wherein the comparator unit (24) is designed to compare the input signal (F) with the comparator threshold ($F_s$), to monitor the input signal (F) with regard to if and when it reaches the comparator threshold ($F_s$), and to signal a switchover event when the comparator threshold is reached,
   - a default unit (28) that is designed to specify a new comparator threshold ($F_s$) triggered by the switchover event in that a second, anticipated argument value is specified, and the new comparator threshold ($F_s$) is calculated therefrom by at least approximately determining the value of the function of a second anticipated argument value,
   - and an output unit (26) to output an output signal (P) depending on the comparator signal.

2. The sensor device according to claim 1, wherein:

   - the default unit (28) is designed to specify a sequence of anticipated argument values each triggered by the comparator signal, and to calculate a sequence of comparator threshold values ($F_s$) therefrom.

3. The sensor device according to claim 2, wherein:

   - The sequence of anticipated argument values is equidistant.

4. The sensor device according to one of the preceding claims, wherein:

   - the argument is an angular value ($\alpha$),
   - and the function is a sine or cosine function.

5. The sensor device according to one of the preceding claims, wherein:

   - the output signal (P) is a clocked signal, the clocking of which depends on the times of the comparator signal.

6. The sensor device according to one of the preceding claims, wherein:

   - a multiplexer (38) is provided in order to continuously supply the input signal (F) to a comparator (40) such that either only a rising edge of the input signal is always present upon each switchover event, or only a falling edge of the input signal is always present upon each switchover event, and/or the input signal is inverted.

7. The sensor device according to one of the preceding claims, wherein:

   - the input signal (F) has at least one first signal component and one second signal component, wherein the first and second signal component vary according to the same function, but with a phase shift depending on the argument (A, $\alpha$),
   - wherein a multiplexer (38) is present for always supplying of the input signal (F) only the steeper signal component to the comparator (40) for the next switchover event.

8. The sensor device according to one of the preceding claims, wherein:

   - the default unit (28) approximately calculates the function using a polynomial in determining the new comparator threshold ($F_s$).

9. The sensor device according to one of the preceding claims, wherein:

   - a peak value detector (36) is provided for the input signal (F),
   - and the default unit (28), when calculating the new comparator threshold value ($F_s$), uses the peak value of the input signal (F) supplied by the peak value detector (36).

10. The sensor device according to one of the preceding claims, wherein:

- the output unit (26) is designed to form and output a pulse signal (P) that is synchronous with the times of the switchover event.

11. The sensor device according to one of the preceding claims, wherein:

- a first and second periodic input signal with different partitioning are processed,
- wherein to process the first input signal, the comparator unit is present as the first comparator unit and the default unit is present as the first default unit for comparing the first input signal with a first comparator threshold and generating the comparator signal as the first comparator signal ($K_1$),
- and to process the second input signal, there is a second comparator unit and second default unit for comparing the second input signal with at least one second comparator threshold and for generating a second comparator signal ($K_2$).

12. The sensor device according to claim 12, wherein:

- the second comparator (40b) is designed as a window comparator for comparing using a bottom and top threshold,
- wherein a trigger signal (T) is only output when the value of the second signal ($F_2$) lies within a window between the top and bottom threshold upon a switchover event of the first comparator unit.

13. A method for generating an output signal (P) that is synchronous with times of switchover events and contains a pulse edge consisting of at least one sensor signal of a sensor arrangement as an input signal (F) that varies according to a known function of an argument (A, $\alpha$), wherein:

- a comparator unit signals switchover events by generating a comparator signal in that it compares the input signal (F) with a comparator threshold ($F_s$), monitors the input signal (F) with regard to if and when it reaches the comparator threshold ($F_s$), and generates the comparator signal upon reaching the comparator threshold value,
- wherein the comparator threshold ($F_s$) is set such that it corresponds to the value of the function upon a first anticipated argument value,
- and wherein a new comparator threshold ($F_s$) is specified when triggered by the signaling of the switchover event in that a second, anticipated argument value is specified, and the new comparator threshold ($F_s$) is calculated therefrom by at least approximately determining the value of the function for the second anticipated argument value,
- and wherein an output signal (P) is output depending on the comparator signal.

**Revendications**

1. Dispositif de capteur, avec

- un agencement de capteur (14) pour la génération d'un signal de capteur (F)
- et un dispositif (12) pour la génération d'un signal de sortie (P) synchrone avec des instants d'événements de commutation au moins à partir du signal de capteur (F) qui varie selon une fonction d'un argument (A, $\alpha$) connue pour le dispositif de capteur, et le signal de capteur (F) étant acheminé au dispositif (12) en tant que signal d'entrée, et le signal de sortie (P) contenant un flanc d'impulsion, le dispositif (12) comprenant
- une unité de comparateur (24) pour la signalisation d'événements de commutation au moyen de la génération d'un signal de comparateur, avec une valeur de seuil de comparateur pouvant être réglée à une valeur spécifiée ($F_S$), la valeur de seuil de comparateur étant réglée de telle sorte qu'elle correspond à la valeur de la fonction dans le cas d'une première valeur d'argument attendue, et l'unité de comparateur (24) étant conçue pour comparer le signal d'entrée (F) à la valeur de seuil de comparateur ($F_S$), pour surveiller ensuite le signal d'entrée (F) afin de déterminer si et quand il atteint la valeur de seuil de comparateur ($F_S$) et pour signaler un événement de commutation lorsque la valeur de seuil de comparateur est atteinte,
- une unité de spécification (28), conçue pour, quand elle est déclenchée par l'événement de commutation, spécifier une nouvelle valeur de seuil de comparateur ($F_S$) par le fait qu'une deuxième valeur d'argument attendue est spécifiée et, à partir de là, la nouvelle valeur de seuil de comparateur ($F_S$) est déterminée par au moins une définition approximative de la valeur de la fonction pour une deuxième valeur d'argument attendue,
- et une unité de sortie (26) pour la délivrance d'un signal de sortie (P) en fonction du signal de comparateur.

2. Dispositif de capteur selon la revendication 1, dans lequel

- l'unité de spécification (28) est conçue pour, quand elle est déclenchée respectivement par le signal de comparateur, spécifier une séquence de valeurs d'argument attendues et déterminer à partir de là une séquence de valeurs de seuil de comparateur (F$_S$).

3. Dispositif de capteur selon la revendication 2, dans lequel

   - la séquence des valeurs d'argument attendues est équidistante.

4. Dispositif de capteur selon l'une des revendications précédentes, dans lequel

   - l'argument est une valeur angulaire ($\alpha$)
   - et la fonction est une fonction sinus ou cosinus.

5. Dispositif de capteur selon l'une des revendications précédentes, dans lequel

   - le signal de sortie (P) est un signal cadencé dont la cadence est fonction des instants des signaux de comparateur.

6. Dispositif de capteur selon l'une des revendications précédentes, dans lequel

   - il est prévu un multiplexeur (38) pour acheminer constamment le signal d'entrée (F) à un comparateur (40) de telle sorte que, soit constamment seulement un flanc montant du signal d'entrée est présent lors de chaque événement de commutation, soit constamment seulement un flanc descendant du signal d'entrée est présent lors de chaque événement de commutation, et/ou le signal d'entrée est inversé.

7. Dispositif de capteur selon l'une des revendications précédentes, dans lequel

   - le signal d'entrée (F) présente au moins une première fraction de signal et une deuxième fraction de signal, la première et la deuxième fraction de signal variant selon la même fonction mais avec un déphasage en fonction de l'argument (A, $\alpha$),
   - un multiplexeur (38) étant présent pour, du signal d'entrée (F), constamment n'acheminer au comparateur (40) que la fraction de signal plus abrupte vers l'événement de commutation le plus proche.

8. Dispositif de capteur selon l'une des revendications précédentes, dans lequel

   - lors de la détermination de la nouvelle valeur de seuil de comparateur (F$_s$), l'unité de spécification (28) calcule de façon approchée la fonction par un polynôme.

9. Dispositif de capteur selon l'une des revendications précédentes, dans lequel

   - il est prévu un détecteur de valeur de pointe (36) pour le signal d'entrée (F),
   - et, lors de la détermination de la nouvelle valeur de seuil de comparateur (F$_S$), l'unité de spécification (28) utilise la valeur de pointe du signal d'entrée (F) fournie par le détecteur de valeur de pointe (36).

10. Dispositif de capteur selon l'une des revendications précédentes, dans lequel

    - l'unité de sortie (26) est constituée pour former et délivrer un signal impulsionnel (P) synchrone avec les instants de l'événement de commutation.

11. Dispositif de capteur selon l'une des revendications précédentes, dans lequel

    - un premier et un deuxième signal d'entrée périodique de division différente sont traités,
    - pour le traitement du premier signal d'entrée, l'unité de comparateur étant présente en tant que première unité de comparateur, et l'unité de spécification étant présente en tant que première unité de spécification pour comparer le premier signal d'entrée avec une première valeur de seuil de comparateur et pour générer le signal de comparateur en tant que premier signal de comparateur (K$_1$),
    - et, pour le traitement du deuxième signal d'entrée, une deuxième unité de comparateur et une deuxième unité de spécification étant présentes pour comparer le deuxième signal d'entrée avec au moins une deuxième valeur de seuil de comparateur et pour générer un deuxième signal de comparateur (K$_2$).

12. Dispositif de capteur selon la revendication 12, dans lequel

    - le deuxième comparateur (40b) est constitué en tant que comparateur à fenêtre pour la comparaison avec un seuil inférieur et un seuil supérieur,
    - un signal de déclenchement (T) n'étant délivré que si, lors d'un événement de commutation de la première unité de comparateur, la valeur du deuxième signal (F$_2$) est située dans une fenêtre entre le seuil supérieur et le seuil inférieur.

13. Procédé de génération d'un signal de sortie (P) synchrone avec des instants d'événements de commutation qui contient un flanc d'impulsion, à partir d'au moins un signal de capteur d'un agencement de capteur en tant que signal d'entrée (F) qui varie selon une fonction connue d'un argument (A, α), dans lequel

- une unité de comparateur signale des événements de commutation au moyen de la génération d'un signal de comparateur en comparant le signal d'entrée (F) avec une valeur de seuil de comparateur ($F_S$), en surveillant ensuite le signal d'entrée (F) pour déterminer si et quand il atteint la valeur de seuil de comparateur ($F_S$), et en générant le signal de comparateur lorsque la valeur de seuil de comparateur est atteinte,
- la valeur de seuil de comparateur ($F_S$) étant réglée de telle sorte qu'elle correspond à la valeur de la fonction lors d'une première valeur d'argument attendue,
- et, déclenchée par la signalisation de l'événement de commutation, une nouvelle valeur de seuil de comparateur ($F_S$) est spécifiée par le fait qu'une deuxième valeur d'argument attendue est présente et, à partir de là, la nouvelle valeur de seuil de comparateur ($F_S$) est déterminée par au moins une définition approximative de la valeur de la fonction pour la deuxième valeur d'argument attendue,
- et un signal de sortie (P) étant délivré en fonction du signal de comparateur.

Fig. 1

Fig. 2

Fig. 3

Fig. 4

Fig. 5

Fig. 6

Fig. 7

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19543564 A1
- DE 10041736 C1
- DE 19701260 C2
- DE 2519417 A1
- DE 3409795 A1
- US 20040202245 A1
- US 20060071964 A1
- US 20080106273 A1
- US 6490807 B1
- WO 2003038379 A
- EP 1666836 A2